# EUROPEAN PATENT APPLICATION

(11) **EP 2 787 019 A1**
(43) Date of publication of application: **08.10.2014**
(21) Application number: 11876538.7
(22) Date of filing: 30.11.2011
(51) Int. Cl.: C08G 61/12, C09K 11/06

(54) **CO-POLYMER OF 2,7-CARBAZOLE AND DITHIENYL THIAZOLOTHIAZOLE, AND METHOD FOR PREPARING SAME AND SOLAR BATTERY CONTAINING SAME**

(71) Applicant: Ocean's King Lighting Science & Technology Co., Ltd, Shenzhen, Guangdong 518000 (CN); Shenzhen Ocean's King Lighting Engineering Co., Ltd., Shenzhen, Guangdong 518000 (CN)
(72) Inventor: ZHOU, Mingjie, Shenzhen Guangdong 518000 (CN); WANG, Ping, Shenzhen Guangdong 518000 (CN); ZHANG, Zhenhua, Shenzhen Guangdong 518000 (CN); FENG, Xiaoming, Shenzhen Guangdong 518000 (CN)
(74) Representative: Lenthall, Joseph
(86) International application number: PCT/CN2011/083210
(87) International publication number: WO 2013/078635

(57) **Abstract**

Provided are a co-polymer of formula (I) of 2,7 -carbazole and dithienyl thiazolothiazole, a method for preparing same, and a solar battery containing same. The structural formula of the co-polymer of 2,7 -carbazole and dithienyl thiazolothiazole is as shown by formula (I), wherein both R₁ and R₂ are C₁-C₂₀ alkyl groups, and n is an integer of 10-100. The co-polymer of the present invention has a novel structure, a good dissolving property, an excellent film-forming property, and a high power conversion efficiency, and can be used as the material for a solar battery. Also provided are the method for preparing the co-polymer and the solar battery containing same. The preparation method uses raw materials widely available and has a simple synthesis route.

## Description

### FIELD OF THE INVENTION

The present invention relates to the field of organic solar battery material, more particularly to co-polymer of 2,7-carbazole and dithienyl thiazolothiazole, method for preparing the same and solar battery containing the same.

### BACKGROUND OF THE INVENTION

A persistent difficulty and hotspot in the field of photovoltaics is to prepare low-cost, high-effect solar cells using cheap materials. Organic semiconductor material has attracted considerable attention owing to its advantages of available raw material, low cost, simple process, good environmental stability and good photovoltaic effect. Since photo-induced electron transfer phenomenon between conjugated polymer and C₆₀ was reported on Science (N. S Sariciftci, L. S milowitz, A. J. Heeger, et al. Science, 1992, 258, 1474) by N. S. Sariciftci, et al. in 1992, organic solar battery is becoming a hot topic. A rapid development has been achieved in recent years. However, the conversion efficiency of organic solar battery is much lower than that of inorganic solar battery. In order to promote practical use of organic polymer solar battery, developing new material having high power conversion efficiency is the most important task.

### SUMMARY OF THE INVENTION

In order to solve the problem of low conversion efficiency of organic solar battery, the present invention provides 2,7-carbazole and dithienyl thiazolothiazole. The co-polymer having novel structure, good solubility, excellent film-forming property, high power conversion efficiency, can be used as solar battery material. The present invention still provides a method for preparing the same and solar battery containing the same. The preparation method uses raw materials widely available and has a simple synthesis route.

One aspect of the present invention is to provide a co-polymer of 2,7-carbazole and dithienyl thiazolothiazole represented by formula (I): 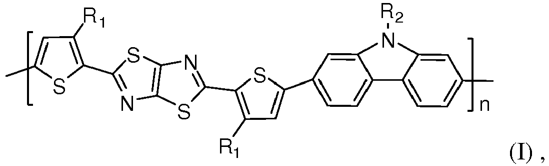 where R₁ and R₂ are C₁-C₂₀ alkyl, n is an integer between 10 and 100.

In preferred embodiments, R₁ and R₂ are the same or different, which are selected from CH₃, C₈H₁₇ and C₂₀H₄₁.

Another aspect of the present invention is to provide a method for preparing 2,7-carbazole and dithienyl thiazolothiazole represented by formula (I), comprising:
(1) Providing compound A and compound B represented by the following formula separately: 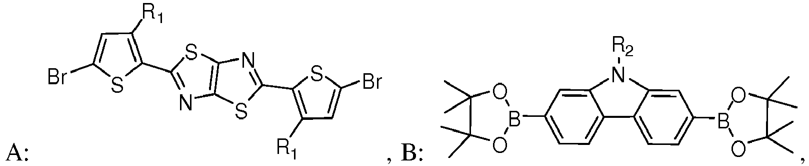 where R₁ and R₂ are C₁-C₂₀ alkyl;
(2)In an oxygen-free environment, adding the compound A and compound B in a molar ratio of 1:1-1.2 into organic solvent containing catalyst; heating the mixture and conducting Suzuki coupling reaction; cooling to room temperature, then stopping the reaction; adding methanol to the solution obtained in the previous step to precipitate, then extracting with Soxhlet extractor; conducting extraction under pressure by methanol and n-hexane successively; conducting extraction using chloroform as an extractant until the solution in the previous step becomes colorless; collecting chloroform solution and evaporating to give red powders; vacuum drying the red powders, and co-polymer represented by formula (I) is obtained: 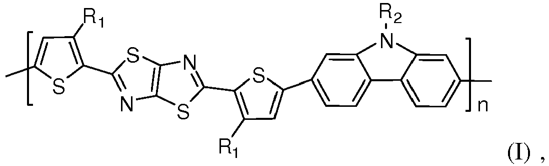 where R₁ and R₂ are C₁-C₂₀ alkyl, n is an integer between 10 and 100.

In preferred embodiments, R₁ and R₂ are the same or different, which are selected from CH₃, C₈H₁₇ and C₂₀H₄₁.

In preferred embodiments, catalyst is mixture of inorganic base and organopalladium, or mixture of organopalladium and organic phosphorus ligand.

In preferred embodiments, inorganic base is potassium carbonate, sodium carbonate or sodium bicarbonate.

In preferred embodiments, organopalladium is bis(triphenylphosphine)palladium(II) dichloride, tetrakis(triphenylphosphine) palladium(0), or tris(dibenzylideneacetone)dipalladium. Molar ratio of the organopalladium to the compound A is in the range of 1:20-100. In more preferred embodiments, molar ratio of the organopalladium to the compound A is in the range of 1:40-80.

In preferred embodiments, organic phosphorus ligand is tri-tert-butylphosphine, tri(p-tolyl)phosphine or 2-dicyclohexylphosphino-2',6'-dimethoxybiphenyl.

In preferred embodiments, in the mixture of organopalladium and organic phosphorus ligand, molar ratio of the organopalladium to the organic phosphorus ligand is in the range of 1:4-8.

In preferred embodiments, the organic solvent is at least one selected from methylbenzene, N,N-dimethylformamide and tetrahydrofuran.

In preferred embodiments, Suzuki coupling reaction is carried out at 70-130°C for 12-96 hours.

In more preferred embodiments, Suzuki coupling reaction is carried out at 90-100°C for 36-72 hours.

Yet another aspect of the present invention is to provide solar battery comprising anode layer, active layer and cathode layer stacked in sequence, wherein electron donor material of active layer is co-polymer of 2,7-carbazole and dithienyl thiazolothiazole as previously described.

The present invention provides co-polymer of 2,7-carbazole and dithienyl thiazolothiazole having novel structure. This is the first study to polymerize 2,7-carbazole and thiazole to get a polymer having good solubility, excellent film-forming property and high power conversion efficiency. As a promising conjugated polymer, poly(2,7-carbazole) derivatives were first successfully synthesized by Leclerc's team in 2001. Poly(2,7-carbazole) derivatives have excellent photophysical properties, such as good hole-mobility, chemical stability and easy to be modified. Band gap can be easily controlled by adjusting different acceptor unit. Thiazole is a typical electron-deficient unit, which contains electron-withdrawing imine group. The co-polymer exhibits great hole-mobility due to the thiazolothiazole group on its backbone. Linking two more thienyl groups to every unit can lower band gap of co-polymer.

The present invention still provides a method for preparing the same and solar battery containing the same. The preparation method uses raw materials widely available and has a simple synthesis route.

### BRIEF DESCRIPTION OF THE DRAWINGS

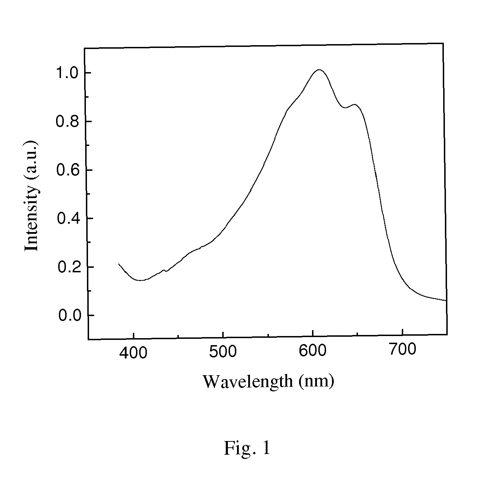

Fig. 1 is UV-VIS spectrum of the poly[2,5-bis(3-octyl-2-thiophene)thiazolo [5,4-d]thiazole -co- N-octylcarbazole] prepared in Example 1.

### DETAILED DESCRIPTION OF ILLUSTRATED EMBODIMENTS

The details of some preferred embodiments are set forth in the accompanying drawings and description below. Monomer A herein can be synthesized referring to the method disclosed in Journal of Advanced Materials, 2007, 19, 4160, or purchased from the market. Monomer B herein can be synthesized referring to the method disclosed in Macromolecules, 2008, 41, 6012, or purchased from the market. It will be apparent to those skilled in the art that many changes and substitutions can be made to the preferred embodiment s herein described without departing from the spirit and scope of the present invention as defined by the appended claims. Consequently, these changes and substitutions are within the scope of the present invention.

### Example 1

Poly[2,5-bis(3-octyl-2-thiophene)thiazolo[5,4-d]thiazole -co- N-octylcarbazole] represented by formula (II): 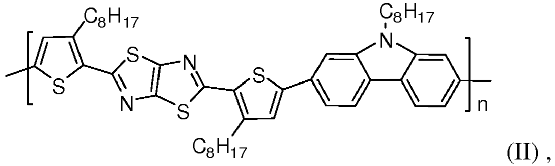 n is an integer between 10 and 100.

The preparation method is as follows:
Provided were compound A and compound B represented by the following formulas separately:

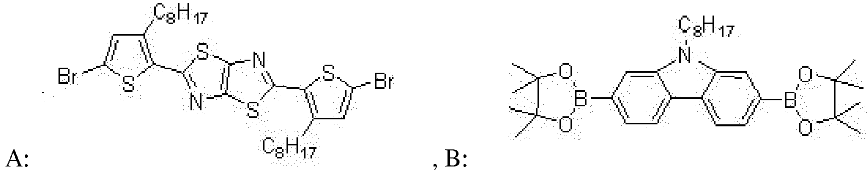

The reaction equation is:

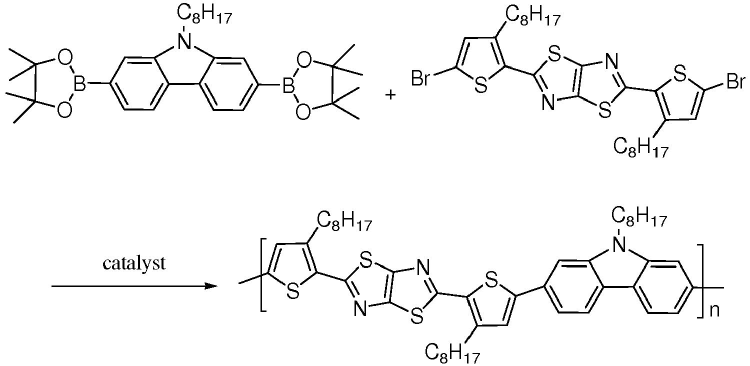

Under the protection of nitrogen, mixture of 2,5-bis(5-bromo-3-octyl-2-thiophene)thiazolo[5,4-d]thiazole (257 mg, 0.3 mmol), N-octylcarbazole-2,7-bis(boronic acid pinacol ester) (159 mg, 0.3 mmol), tris(dibenzylideneacetone)dipalladium (13.75 mg, 0.015 mmol) and 2-dicyclohexylphosphino-2',6'-dimethoxybiphenyl (42 mg, 0.1 mmol) was dissolved in 12 mL of methylbenzene. Solution of potassium carbonate (3 mL, 2 mol/L) was added to the mixed solution obtained in the previous step, followed by continued supply of nitrogen to expel air for about 30 min. The Suzuki coupling reaction was carried out for 72 h while stirring at 90°C. The mixture was cooled to room temperature, and then the reaction was stopped. 40 mL of methanol was added to the solution obtained in the previous step to precipitate, followed by extraction with Soxhlet extractor. Then extraction was conducted under pressure using methanol and n-hexane for 24 hours successively. Then using chloroform as an extractant to extract until the solution obtained in the previous step became colorless. Chloroform solution was collected and evaporated to give red powders. The red powders were then dried at 50°C under vacuum for 24 h to obtain final product. The yield is 76%.

The test results were: Molecular weight (GPC, THF, R. I): Mₙ =55.9kDa, M_{w}/Mₙ =2.2.

### Example 2

Poly[2,5-bis(3-methyl-2-thiophene)thiazolo[5,4-d]thiazole -co-N-eicosylcarbazole] represented by formula (III): 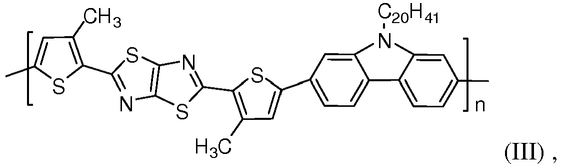 n is an integer between 10 and 100.

The preparation method is as follows:
Provided were compound A and compound B represented by the following formulas separately:

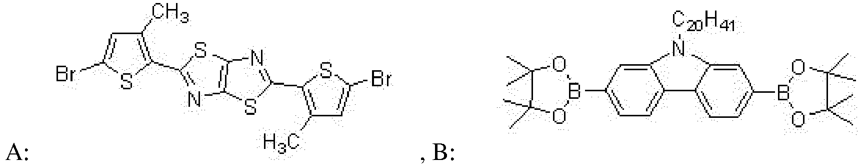

The reaction equation is:

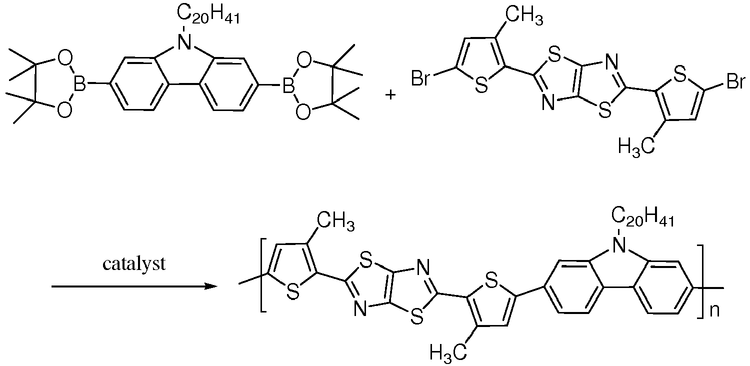

Under the protection of nitrogen, mixture of 2,5-bis(5-bromo-3-methyl-2-thiophene)thiazolo[5,4-d]thiazole (98 mg, 0.2 mmol), and N-eicosylcarbazole-2,7-bis(boronic acid pinacol ester) (140 mg, 0.2 mmol) was dissolved in 15 mL of N,N-dimethylformamide. Solution of sodium carbonate (2 mL, 2 mol/L) was added to the solution obtained in the previous step. After vacuumizing to expel oxygen and supplying nitrogen, bis(triphenylphosphine)palladium(II) dichloride (5 mg, 0.007 mmol) was added. Suzuki coupling reaction was carried out for 36 h while stirring at 110°C. The mixed solution obtained in the previous step was cooled to room temperature then added to 50 mL of methanol to precipitate. After filtrating with Soxhlet extractor, then extraction was conducted under pressure using methanol and n-hexane for 24 hours successively. Then using chloroform as an extractant to extract until the solution obtained in the previous step became colorless. Chloroform solution was collected and evaporated to give red powders. The red powders were then dried under vacuum overnight to obtain final product. The yield is 55%.

The test results were: Molecular weight (GPC, THF, R. I): Mₙ = 44.5kDa, M_{w}/Mₙ =2.3.

### Example 3

Poly[2,5-bis(3-eicosyl-2-thiophene)thiazolo[5,4-d]thiazole -coN-methylcarbazole] represented by formula (IV): 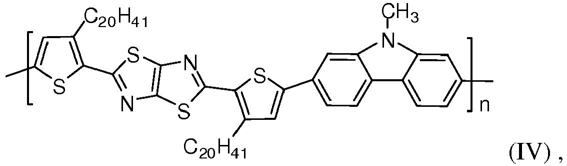 n is an integer between 10 and 100.

The preparation method is as follows:
Provided were compound A and compound B represented by the following formulas separately:

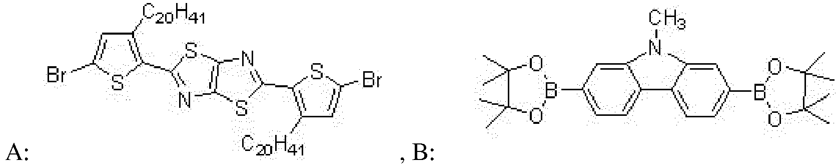

The reaction equation is:

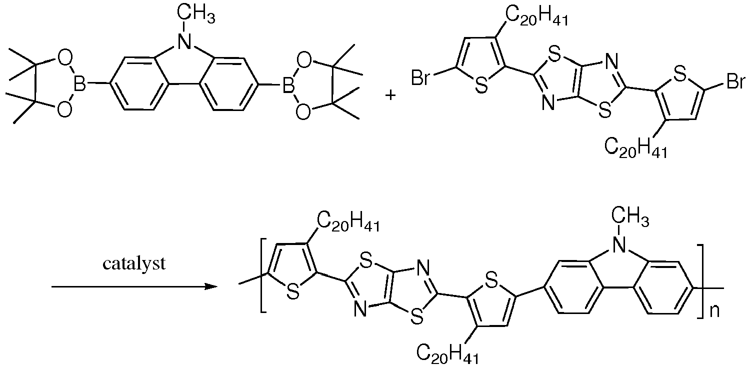

Under the protection of nitrogen, 2,5-bis(5-bromo-3-eicosyl-2-thiophene)thiazolo[5,4-d]thiazole (308 mg, 0.3 mmol), N-methylcarbazole-2,7-bis(boronic acid pinacol ester) (130 mg, 0.3 mmol) and 15 mL of tetrahydrofuran were added to a 50 mL two-neck flask. After vacuumizing to expel oxygen and supplying nitrogen for about 20 min, tetrakis(triphenylphosphine) palladium(0) (3.73 mg, 0.003 mmol) was added to the flask, followed by addition of solution of sodium bicarbonate (3 mL, 2 mol/L). After vacuumizing to expel oxygen and supplying nitrogen for about 10 min, Suzuki coupling reaction was carried out for 96 h while stirring at 70°C. The mixture was cooled to room temperature, and then the reaction was stopped. 40 mL of methanol was added to the solution obtained in the previous step to precipitate, followed by extraction with Soxhlet extractor. Then extraction was conducted under pressure using methanol and n-hexane for 24 hours successively. Then using chloroform as an extractant to extract until the solution obtained in the previous step became colorless. Chloroform solution was collected and evaporated to give red solids. The red solids were then dried at 50°C under vacuum for 24 h to obtain final product. The yield is 84%.

The test results were: Molecular weight (GPC, THF, R. I): Mₙ =68.1 kDa, M_{w}/Mₙ =2.1.

### Example 4

Poly[2,5-bis(3-octyl-2-thiophene)thiazolo[5,4-d]thiazole -co- N-octylcarbazole] represented by formula (II): 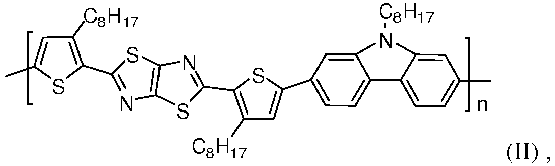 n is an integer between 10 and 100.

The preparation method is as follows:
Provided were compound A and compound B represented by the following formulas separately:

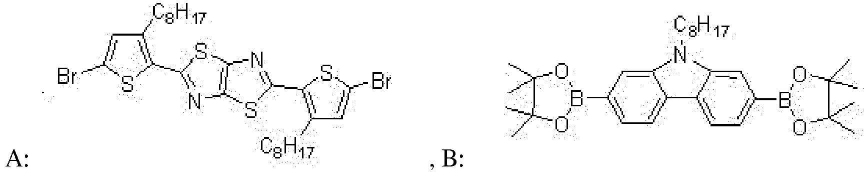

The reaction equation is:

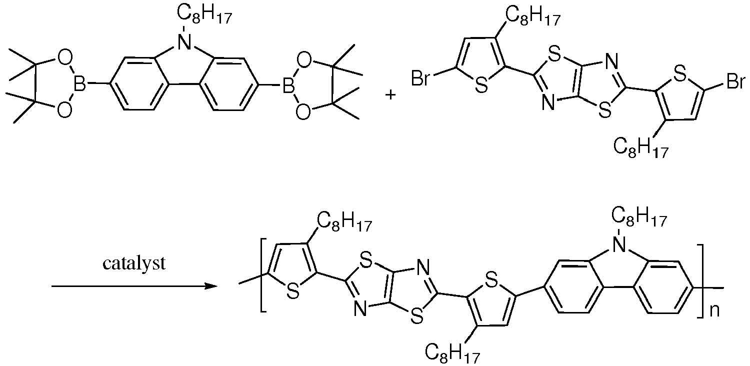

Under the protection of nitrogen, mixture of 2,5-bis(5-bromo-3-octyl-2-thiephene)thiazolo[5,4-d]thiazole (257 mg, 0.3 mmol), N-octylcarbazole-2,7-bis(boronic acid pinacol ester) (159 mg, 0.36 mmol), tris(dibenzylideneacetone)dipalladium (13.75 mg, 0.015 mmol) and 2-dicyclohexylphosphino-2',6'-dimethoxybiphenyl (42 mg, 0.10 mmol) was dissolved in 12 mL of methylbenzene. Solution of potassium carbonate (3 mL, 2 mol/L) was added to the mixed solution obtained in the previous step, followed by continued supply of nitrogen to expel air for about 30 min. The Suzuki coupling reaction was carried out for 12 h while stirring at 130°C. The mixture was cooled to room temperature, and then the reaction was stopped. 40 mL of methanol was added to the solution obtained in the previous step to precipitate, followed by extraction with Soxhlet extractor. Then extraction was conducted under pressure using methanol and n-hexane for 24 hours successively. Then using chloroform as an extractant to extract until the solution obtained in the previous step became colorless. Chloroform solution was collected and evaporated to give red powders. The red powders were then dried at 50°C under vacuum for 24 h to obtain final product. The yield is 76%.

The test results were: Molecular weight (GPC, THF, R. I): Mₙ =55.9kDa, M_{w}/Mₙ =2.2.

### Example illustrating the effects

UV-VIS spectrum of the poly[2,5-bis(3-octyl-2-thiophene)thiazolo [5,4-d]thiazole -co- N-octylcarbazole] prepared in Example 1 is shown in Fig. 1. It can be seen from Fig. 1 that a relatively strong absorption peak appears in the range of 350 nm-750 nm. Maximum absorption peak occurred at 611 nm.

## Claims

1. A co-polymer of 2,7-carbazole and dithienyl thiazolothiazole represented by formula (I): 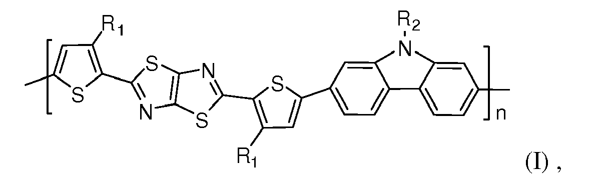 where R₁ and R₂ are C₁-C₂₀ alkyl, n is an integer between 10 and 100.

2. A method for preparing co-polymer of 2,7-carbazole and dithienyl thiazolothiazole, comprising:
(1) Providing compound A and compound B represented by the following formulas separately: 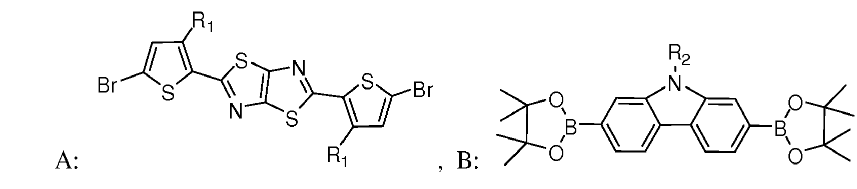 where R₁ and R₂ are C₁-C₂₀ alkyl;
(2) In an oxygen-free environment, adding the compound A and compound B in a molar ratio of 1:1-1.2 into organic solvent containing catalyst; heating the mixture and conducting Suzuki coupling reaction; cooling to room temperature, then stopping the reaction; adding methanol to the solution obtained in the previous step to precipitate, then extracting with Soxhlet extractor; conducting extraction under pressure by methanol and n-hexane successively; conducting extraction using chloroform as an extractant until the solution obtained in the previous step becomes colorless; collecting chloroform solution and evaporating to give red powders; vacuum drying the red powders, and co-polymer represented by formula (I) is obtained: 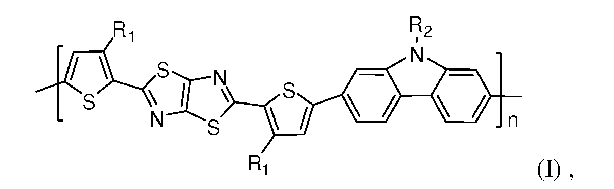 Where R₁ and R₂ are C₁-C₂₀ alkyl, n is an integer between 10 and 100.

3. The method according to claim 2, wherein the catalyst in step (2) is mixture of inorganic base and organopalladium, or mixture of organopalladium and organic phosphorus ligand.

4. The method according to claim 3, wherein the inorganic base is potassium carbonate, sodium carbonate or sodium bicarbonate.

5. The method according to claim 3, wherein the organopalladium is bis(triphenylphosphine)palladium(II) dichloride, tetrakis(triphenylphosphine) palladium(0), or tris(dibenzylideneacetone)dipalladium; molar ratio of the organopalladium to the compound A is in the range of 1:20-100.

6. The method according to claim 3, wherein the organic phosphorus ligand is tri-tert-butylphosphine, tri(p-tolyl)phosphine or 2-dicyclohexylphosphino-2',6'-dimethoxybiphenyl.

7. The method according to claim 6, in the mixture of organopalladium and organic phosphorus ligand, molar ratio of the organopalladium to the organic phosphorus ligand is in the range of 1:4-8.

8. The method according to claim 2, wherein the organic solvent in step (2) is at least one selected from methylbenzene, N,N-dimethylformamide and tetrahydrofuran.

9. The method according to claim 2, wherein the Suzuki coupling reaction is carried out at 70-130°C for 12-96 hours.

10. A solar battery, comprising anode layer, active layer and cathode layer stacked in sequence, wherein electron donor material of the active layer is co-polymer of 2,7-carbazole and dithienyl thiazolothiazole according to claim 1.
